Europäisches Patentamt

European Patent Office

Office européen des brevets

(11) Publication number: **0 517 411 A1**

# EUROPEAN PATENT APPLICATION

(21) Application number: **92304735.1**

(22) Date of filing: **26.05.92**

(51) Int. Cl.5: **G11B 5/64**

(30) Priority: **03.06.91 JP 160043/91**

(43) Date of publication of application:
**09.12.92 Bulletin 92/50**

(84) Designated Contracting States:
**DE GB**

(71) Applicant: **Hitachi Maxell Ltd.**
**1-88, Ushitora-1-chome, Ibaraki-shi**
**Osaka-fu(JP)**

(72) Inventor: **Kubota, Takashi**
**8-8-302 Amakubo-2-chome**
**Tsukuba-shi(JP)**

Inventor: **Iimura, Makoto**
**4300 Takasai**
**Shimotsuma-shi(JP)**
Inventor: **Asano, Michio**
**127-1 Obokawa, Ishigemachi**
**Yuki-gun, Ibaraki-ken(JP)**
Inventor: **Yamashita, Sadao**
**1077-1 Yamadamachi**
**Mitsukaido-shi(JP)**

(74) Representative: **Williams, Trevor John**
**J.A. KEMP & CO. 14 South Square Gray's Inn**
**London WC1R 5LX(GB)**

(54) **Magnetic recording medium.**

(57) There is provided a thin film type magnetic recording medium with excellent electromagnetic conversion characteristics, according to the present invention.

When a ferromagnetic metal layer is formed on a non-magnetic base film by a continuous oblique vapor deposition method, the lower portion of the ferromagnetic metal layer has an obliquely incident columnar particle structure in which the angle between the lengthwise direction of the non-magnetic base film and a particle growing direction is decreased as the lower portion is apart from the boundary thereof (high incident angle portion) with the non-magnetic base film and the upper portion of the ferromagnetic metal layer has an obliquely incident columnar particle structure in which the angle between the lengthwise direction of the non-magnetic base film and the particle growing direction is increased as the upper portion thereof approaches the uppermost surface portion of the ferromagnetic metal layer (low incident angle portion).

FIG. I

Background of the Invention

Field of the Invention

The present invention relates to a magnetic recording medium, and more specifically, to a magnetic recording medium with improved electromagnetic conversion characteristics.

Description of the Related Art

As a high density recording technology is more required, technologies in various fields such as an optical recording, semiconductor memory and the like have been actively improved. In particular, in the field of a magnetic recording, a magnetic thin film using a ferromagnetic metal or an alloy thereof as a high density recording material has been extensively studied, in place of a conventional magnetic-powder-coated-type recording medium.

In general, a thin film type magnetic recording medium having a magnetic layer composed of a ferromagnetic metal or an alloy thereof is formed in such a manner that the ferromagnetic metal or the alloy thereof is melted by being irradiated with an electron beam in a crucible disposed in a vacuum vessel and a heated and evaporated metal vapor is deposited on a non-magnetic base film composed of a plastic film of polyester or the like in an atmosphere to which an oxygen-containing gas is introduced.

When the above ferromagnetic metal is used to form to a magnetic recording layer on a lengthwise medium such as a magnetic tape and the like, a method of forming an oblique vapor-deposited film using a continuous evaporation apparatus is employed. According to this method, a vapor deposition is carried out by continuously decreasing an angle of a vapor to be deposited, which is incident on the non-magnetic base film traveling in contact with a rotary drum disposed in the vacuum vessel, from the boundary with the non-magnetic base film (high incident angle portion) to the uppermost portion of a ferromagnetic metal layer (low incident angle portion). Nevertheless, it can be anticipated that the ferromagnetic metal layer obtained by this method has a little degraded reproduction output particularly in a short wavelength region because the ferromagnetic metal columnar particles are not sufficiently fine at the high incident angle portion and the particles have a low density.

An object of the present invention is to solve the problem that the above conventional recording mediums have a low reproduction output in a short wavelength region to thereby provide a thin film type magnetic recording medium with improved electromagnetic conversion characteristics.

Summary of the Invention

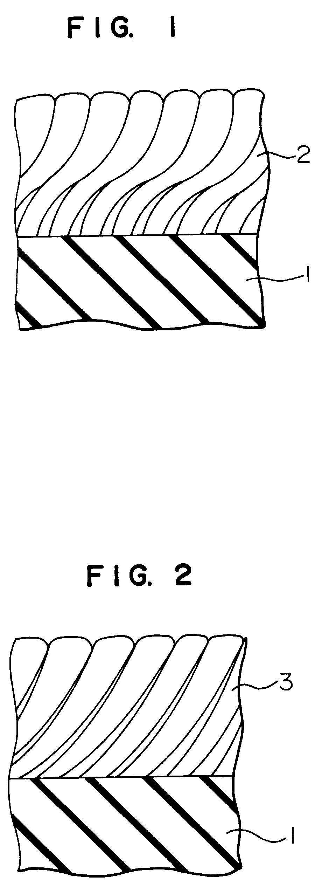

As a result of extensive experiments carried out for long years, the inventors have found that a reproduction output is increased particularly in a short wavelength region by forming a substantially S-shaped ferromagnetic metal layer shown in Figure 1 on a non-magnetic base film by a continuous oblique vapor deposition method, wherein the ferromagnetic metal layer is such that the lower portion thereof has an obliquely incident columnar particle structure in which the angle between the lengthwise direction of the non-magnetic base film and a particle growing direction is decreased as the lower portion is apart from the boundary thereof (high incident angle portion) with the non-magnetic base film and the upper portion thereof has an obliquely incident columnar particle structure in which the angle between the lengthwise direction of the non-magnetic base film and the particle growing direction is increased as the upper portion approaches the uppermost surface portion of the ferromagnetic metal layer (low incident angle portion).

Brief Description of the Drawings

Figure 1 is a conceptual cross sectional view showing the arrangement of a magnetic recording medium according to the present invention; and
Figure 2 is a conceptual cross sectional view showing the arrangement of a magnetic recording medium having a conventional obliquely-vapor-deposited ferromagnetic metal layer.
In these figures:
1 designates a non-magnetic base film;
2 designates a substantially S-shaped ferromagnetic metal layer; and
3 designates a conventional obliquely-vapor-deposited ferromagnetic metal layer.

Description of the Preferred Embodiments

When an underlayer of a ferromagnetic metal layer is grown in such a manner that the angle between the lengthwise direction of a non-magnetic base film and the direction in which particles are grown is decreased (in other words, in such a manner that a high incident angle portion stands upward from the non-magnetic base film) as the lower portion is apart from the boundary (the high incident angle portion) with the non-magnetic base film, the particles of the initially grown layer of the ferromagnetic metal layer are finely and closely grown, and thus the ferromagnetic metal layer grown in orientation with the initially grown layer is considered to have a magnetic domain structure suitable for a high density recording, although this is a mere conjecture because a mechanism by which a reproduction output in a short wavelength region is increased by forming a substantially S-shaped ferromagnetic metal layer as shown in Figure 1 is not yet correctly solved.

This substantially S-shaped ferromagnetic metal layer shown in Figure 1 has a "turning point" of the angle from the lengthwise direction of the non-magnetic base film to the direction in which the particles are grown between the boundary of the non-magnetic base film and the uppermost layer of the ferromagnetic metal layer, wherein the term "turning point" means a point at which a differential value of a change of the angle between the lengthwise direction of the non-magnetic base film and the direction in which the particles are grown becomes zero.

The high incident angle portion grown to stand upward from the non-magnetic base film is controlled by a vapor depositing rate of the ferromagnetic metal layer and an introduction amount of an oxygen-containing gas. This high incident angle portion can be relatively easily grown when the ferromagnetic metal layer has a vapor depositing speed greater than 0.05 um/sec. and a ratio of an introduction amount of the oxygen-containing gas to a vapor depositing speed of the ferromagnetic metal layer is greater than 0.04 liters/um, and further it can be easily grown when a high incident angle control plate for promoting the collision and dispersion of a vapor stream and an oxygen-containing gas stream is disposed at the portion of the apparatus where the high incident angle of the ferromagnetic metal layer is provided.

If the layer of the high incident angle portion grown by standing upward from the non-magnetic base film becomes excessively thick, a vertical component becomes magnetically too much, and thus the characteristics as an in-plane magnetic recording medium will be lost. Therefore, a layer thickness of the portion having an obliquely incident columnar particle structure, in which the angle between the lengthwise direction of the non-magnetic base film and the direction in which particles are grown is decreased as the above angle portion is apart from the high incident angle portion, is preferably 50% or less of an entire layer thickness and generally more preferably from 5% to 30% of a thickness of an entire layer. "The obliquely incident columnar particle structure, in which the angle between the lengthwise direction of the non-magnetic base film and the direction in which particles are grown is decreased as the above angle portion is apart from the high incident angle portion" means a portion from the boundary of the non-magnetic base film to the above turning point.

A layer thickness of the ferromagnetic metal layer as a whole is not particularly limited but generally within the range from 500 to 5000 angstroms, preferably from 1000 to 3000 angstroms and most preferably from 1800 to 2300 angstroms.

Further, in the case of the ferromagnetic metal layer without a high incident angle portion grown by standing upward from the surface of the non-magnetic base film as shown in Figure 2, it is considered that an initially grown layer has a very low particle density and further and is liable to be eroded by humidity and corrosive gases entering from the outside.

Many materials including a thin film composed of a ferromagnetic metal selected from Fe, Co and Ni or a thin film mainly composed thereof such as, for example, a thin film composed of Co-Ni, Co-Cr, Co-P, Co-Pt, Co-Ta, Co-Ni-Cr, Co-Cr-Ta, Fe-Ni, Fe-Co, an oxide film thereof or these thin films added with a slight amount of additive elements, and the like can be used for the recording magnetic layer of the magnetic recording medium of the present invention. In particular, a thin film containing 50 at% or more of Co such as, for example, a Co-Ni-O or Co-O thin film is preferable.

As described above, according to the present invention, since the ferromagnetic metal layer is formed while an oxygen-containing gas is introduced, oxygen atoms may be contained in the ferromagnetic metal layer. In this case, the oxygen atoms have a different concentration depending upon the surface portion of the ferromagnetic metal layer, intermediate portion thereof and the boundary of the non-magnetic base film, respectively. In general, the concentration of the oxygen atoms of the surface portion is 1.5 to 6.0 times that of the intermediate portion, the concentration of the oxygen atoms of the boundary is 1.2 to 3.0 times that of the intermediate portion, and the concentration of the oxygen atoms of the surface portion is 0.50 to 5.0 times that of the boundary. Further, the concentration of the oxygen atoms in the ferromagnetic metal layer is preferably within the range from 10 to 30 at% of the entire component elements constituting the ferromagnetic metal layer.

EP 0 517 411 A1

Although a method of manufacturing the magnetic recording medium according to the present invention is not particularly limited, a vacuum vapor deposition method capable of effecting a continuous oblique vapor deposition is preferably employed. As a method of melting the ferromagnetic metal layer or alloys thereof, a heating method using a plasma irradiation gun, resistance heating method and the like may be employed in addition to a melting method using an electron gun.

Further, although a typical example of the magnetic recording medium according to the present invention is a magnetic tape having a base film composed of a synthetic resin film such as polyester film, polyimide film or the like it may be used as a magnetic disk.

The present invention will be described in more detail with reference to examples.

Examples 1, 2 and Comparative Example 1

A 10 micron thick polyethylene terephthalate film and a Co alloy containing 20 at% of Ni were charged in a continuous oblique evaporation apparatus and this apparatus was evacuated to $1 \times 10^{-5}$ Torr. Then, a 0.2 micron thick ferromagnetic metal layer composed of Co-Ni-O was formed on the polyethylene terephthalate film traveling around a rotary drum while an oxygen gas of a predetermined flow rate was introduced into the apparatus. Note, at that time, these example were made such that a ratio of the thickness of a layer having an obliquely incident columnar particle structure, where the angle between the lengthwise direction of the non-magnetic base film and the direction in which particles was grown was decreased as the above angle portion was apart from the boundary of the polyethylene terephthalate base film (high incident angle portion), to that of an entire layer was 25% (Example 1), 15% (Example 2) and 0% (Comparative Example 1). A ratio of an amount of the introduced oxygen gas to a film forming speed of the ferromagnetic metal layer was 0.15 liter/um in Example 1, 0.09 liter/um in Example 2 and 0.03 liter/um in Comparative Example 1.

A ratio of a reproduction output at 10 MHz obtained from the magnetic tape of each example recorded with a sine wave of 10 MHz to a reproduction output at 7 MHz obtained from the magnetic tape of each example recorded with a sine wave of 7 MHz (10MHz/7MHz reproduction output) was measured by using an electromagnetic conversion measuring instrument and this ratio was evaluated as an extension of an output at a short wavelength region. Table 1 shows a standard metal tape ratio of the 10 MHz reproduction output/7 MHz reproduction output of the tape of each example. "The standard metal tape ratio" used here was a magnetic recording tape having a 2.8 micron magnetic coated film composed of powder of Fe particles having a particle size of 0.3 micron blended with a binder.

Table 1

| 10MHz/7MHz Reproduction Output (dB) (Standard Metal Tape Ratio) | |
| --- | --- |
| Example 1 | + 4.5 |
| Example 2 | + 3.5 |
| Comparative Example 1 | + 1.5 |

As apparent from the result shown in Table 1, since the magnetic tapes obtained by Examples 1 and 2 have a 10 MHz reproduction output/7 MHz reproduction output higher than that of the magnetic tape obtained by Comparative Example 1, it can be understood that the electromagnetic conversion characteristics of the magnetic recording medium according to the present invention can be improved.

As described above, according to the present invention, there can be provided a thin film type magnetic recording medium with improved electromagnetic conversion characteristics, by forming a ferromagnetic metal layer arranged such that the lower portion of the ferromagnetic metal layer has an obliquely incident columnar particle structure in which the angle between the lengthwise direction of the non-magnetic base film and a particle growing direction is decreased as the lower portion is apart from the boundary thereof (high incident angle portion) with the non-magnetic base film and the upper portion of the ferromagnetic metal layer has an obliquely incident columnar particle structure in which the angle between the lengthwise direction of the non-magnetic base film and the particle growing direction is increased as the upper portion approaches the uppermost surface portion of the ferromagnetic metal layer (low incident angle portion).

Claims

1. A magnetic recording medium comprising a ferromagnetic metal layer formed on a non-magnetic base

4

film by a continuous oblique vapor deposition method, wherein the lower portion of said ferromagnetic metal layer has an obliquely incident columnar particle structure in which the angle between the lengthwise direction of said non-magnetic base film and a particle growing direction is decreased as said lower portion is apart from the boundary thereof (high incident angle portion) with said non-magnetic base film and the upper portion of said ferromagnetic metal layer has an obliquely incident columnar particle structure in which the angle between the lengthwise direction of said non-magnetic base film and the particle growing direction is increased as said upper portion approaches the uppermost surface portion of said ferromagnetic metal layer (low incident angle portion).

2. A magnetic recording medium according to claim 1, wherein said angle between the lengthwise direction of said non-magnetic base film and said particle growing direction has a turning point located between the boundary of said non-magnetic base film and the uppermost surface of said ferromagnetic metal layer.

3. A magnetic recording medium according to claim 1, wherein the lower portion of said ferromagnetic metal layer has a thickness of 50% or less of a total thickness of the ferromagnetic metal layer.

4. A magnetic recording medium according to claim 3, wherein the lower portion of said ferromagnetic metal layer has a thickness from 5% to 30% of a thickness of an entire layer.

5. A magnetic recording medium according to claim 1, wherein a total thickness of said ferromagnetic metal layer is within the range from 500 to 5000 angstroms.

6. A magnetic recording medium according to claim 5, wherein a total thickness of said ferromagnetic metal layer is within the range from 1000 to 3000 angstroms.

7. A magnetic recording medium according to claim 1, wherein said ferromagnetic metal layer contains more than 50 at% of Co.

8. A magnetic recording medium according to claim 7, wherein said ferromagnetic metal layer contains 10 to 30 at% of oxygen atoms.

# F I G. 1

# F I G. 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | US-A-4 855 175 (KUNIO WAKAI ET AL.) 8 August 1989 <br> * claims 1-3,6,7 * <br> * figures 1,10,11 * <br> --- | 1,5-8 | G11B5/64 |
| A | EP-A-0 274 437 (HITACHI MAXELL) 13 July 1988 <br> * page 6; examples 1,6 * <br> * claims 1-5,7-9 * <br> * figures 1-3 * <br> ----- | 1,5-8 | |

TECHNICAL FIELDS SEARCHED (Int. Cl.5 )

G11B

The present search report has been drawn up for all claims

| Place of search | Date of completion of the search | Examiner |
|---|---|---|
| THE HAGUE | 31 AUGUST 1992 | KLOCKE S. |

EPO FORM 1503 03.82 (P0401)